# EUROPEAN PATENT APPLICATION

(11) **EP 2 690 665 A1**
(43) Date of publication of application: **29.01.2014**
(21) Application number: 12178301.3
(22) Date of filing: 27.07.2012
(51) Int. Cl.: H01L 29/76, H01L 29/66, B82Y 40/00, B82Y 10/00, H01L 29/417

(54) **Single-charge transistor**

(71) Applicant: Hitachi Ltd., Tokyo (JP)
(72) Inventor: Ferrus, Thierry, Cambridge, Cambridgeshire CB3 0HE (GB)
(74) Representative: Piotrowicz, Pawel Jan Andrzej

(57) **Abstract**

A method of isolating an impurity in a single-charge transistor is described. The single-charge transistor (1: Fig. 1) takes the form of a single-electron transistor comprising a channel (4: Fig. 1) formed from n-type monocrystalline silicon and which includes a pair of lateral constrictions (9, 10: Fig. 1) for forming first and second potential barriers (14, 5: Fig. 5a) and a quantum dot (15: Fig. 5a). The method includes, at 50 K, applying a source-drain voltage to the single-electron transistor so as to drive a given drain current through the channel, cooling the single-charge transistor to 4 K while maintaining the given drain current.

## Description

The present invention relates to a single-charge transistor.

Single-charge tunnelling devices, such as single-electron transistors (SETs) and single-electron turnstiles, are well known in the art.

In a single-electron transistor, electron transfer from a source to a drain, via a small, weakly-coupled island, is inhibited by Coulomb blockade due to the charging energy, E_{C}, of the island. The charging energy E_{C} = e²/2C_{Σ}, where C_{Σ} is the total capacitance of the island. Applying a voltage V_{G} to a gate electrode changes the electrostatic energy of the island to Q²/2C_{Σ} +QC_{G}V_{G}/C_{Σ} which is minimized when the charge on the island Q=ne equals -C_{G}V_{G} = Qₒ. By tuning the continuous external variable Qₒ to -(n+1/2)e, the charging energy associated with increasing the number of electrons on the island from n to n+1 vanishes and electrical current can flow between the source and drain. Changing the gate voltage then leads to oscillations in the source-drain current where each period corresponds to increasing or decreasing the charge on the island by one electron.

Temperature of operation of a single-electron transistor is increased by increasing the charging energy, E_{C}, of the island. This is achieved by decreasing the total capacitance, C_{Σ}, of the island. One of the main ways to decrease the total capacitance, C_{Σ}, of the island is to decrease the size of the island. The natural limit of the island is a single atom or ion.

A single-charge transistor having an island formed by a single atom or a single ion is usually referred to as a "single-atom transistor".

A practical single-atom transistor can be fabricated in generally one of two ways.

In one approach, a single donor, such as phosphorous ion, can be incorporated or implanted in silicon and a set of gates are fabricated around the donor to form a transistor. An example of such a transistor and a method of fabrication can be found in Martin Fuechsele et al: "A single-atom transistor", Nature Nanotechnology, volume 7, pages 242 to 246 (2012). This approach can be used to reliably form a single-atom transistor. However, the approach is costly and slow. Moreover, this approach is difficult to scale up and so fabricate large numbers of transistors.

In another approach, a single-electron transistor is fabricated patterning a silicon-on-insulator (SOI) wafer, for example, as described in V. N. Golovach el al.: "Single-dopant resonance in a single-electron transistor", Physical Review, volume B83, page 075401 (2011) and M. Fernando Gonzalez-Zalba et al.: "A hybrid double-dot in silicon", New Journal of Physics, volume 14, page 023050 (2012). This approach relies on an impurity being located in the correct position by chance. Clearly, therefore, this approach cannot be relied upon to yield a single-atom transistor.

The present invention seeks to ameliorate these drawbacks.

According to a first aspect of the present invention there is provided a method comprising, at a first temperature, applying a source-drain bias to a single-charge transistor comprising a source, a drain and a channel running between the source and drain which includes first and second potential barriers spaced along the channel and a region of semiconductor material disposed between the first and second potential barriers and which is doped. Applying the source-drain bias drives a given drain current through the channel. The method comprises cooling the single-charge transistor to a second temperature while maintaining the given drain current through the channel by adjusting the source-drain bias during cooling of the single-charge transistor. The given drain current may be maintained by continuously or repeatedly adjusting the source-drain bias during cooling of the single-charge transistor.

Applying the source-drain bias causes free charge carriers (e.g. electrons) to accumulate adjacent to a potential barrier and thus distort the potential profile at the interface of the potential barrier and semiconductor material region. If a sufficiently high drain current flows through the channel and is maintained during cooling, then band bending at the interface is maintained such that only one free charge carrier occupies the semiconductor material region. The free charge carrier is drawn to one dopant ion. When the source-drain bias is removed, a potential well is formed by the single dopant ion and the semiconductor material region is depleted of free charge carriers.

The given drain current may be between 0 and 10 nA. The given drain current may be between 0.5 nA and 2 nA. The source-drain bias may be between 0 and 1 V.

The method may further comprise, at the second temperature, removing the source-drain voltage.

The single-charge transistor may include a gate and the method may comprise grounding the gate during cooling of the single-charge transistor.

The source-drain voltage has a given value when it is removed at the second temperature and the method may further comprise applying a source-drain voltage having a smaller magnitude than the given source-drain voltage.

The semiconductor material may be silicon (Si). The semiconductor material region may be with an n-type dopant. For example, for silicon, the n-type dopant may be phosphorous (P) or arsenic (As). The semiconductor material region may be with a p-type dopant. For example, for silicon, the p-type dopant may be boron (B) or aluminium (Al). The semiconductor material region may be doped with the dopant to a concentration of at least 2×10¹⁸ cm⁻³, at least 5×10¹⁸ cm⁻³ or at least 1×10¹⁹ cm⁻³.

The source and drain may comprise the semiconductor material. The source and drain may be doped with a dopant to a concentration of at least 5×10¹⁹ cm⁻³ or at least 1×10²⁰ cm⁻³. The source, drain and channel may be formed in the same layer. The source and drain may have a different doping concentration to the channel. The doping concentration may vary along the channel.

The single-charge transistor may be a single-electron transistor.

The potential barriers may take the form of tunnel barriers.

The channel may comprise an elongate region of the semiconductor material. For example, the channel may take the form of semiconductor wire. The channel may have a thickness less 50 nm or less than 20 nm. The channel may have a width no more than 50 nm, no more than 20 nm or no more than 10 nm.

The channel may include at least one set of constrictions. For example, the channel may include first and second constrictions. The constrictions help to form tunnel barriers. The semiconductor material region may be interposed between first and second constrictions.

The first and second potential barriers may comprise regions of material having a conductivity which is lower than the doped semiconductor material region. The first and second potential barriers may comprise regions of the semiconductor material having a lower doping concentration. For example, the regions forming the potential barriers may be lightly doped (e.g. ≤ 1×10¹⁶ cm⁻³) or undoped. The regions forming the potential barriers may comprise a different semiconductor to that forming the semiconductor material region, i.e. the channel comprises a heterostructure. The regions forming the potential barriers may comprise a dielectric material. For example, the potential barriers may comprise silicon dioxide, silicon nitride or silicon oxynitride.

The first and second potential barriers may comprise different materials and/or may have different configurations or dimensions. For example, a first potential barrier can be formed by a region of dielectric material, such as silicon dioxide, and the second potential barrier can be provided by a depletion region in a region of lightly-doped semiconductor material. In another example, a first potential barrier may be formed using a constriction in a highly-doped region of semiconductor material and the second potential barrier may be provided in a region of lightly-doped or updoped semiconductor material.

The single-charge transistor may further include first and second arms oppositely attached to the channel so as to form a cross. The semiconductor material region is disposed at an intersection of the cross. Thus, not only can the position of the dopant ion(s) be manipulated along the channel, but also the position of the dopant ion(s) can be manipulated in a transverse direction.

According to a second aspect of the present invention there is provided apparatus comprising a single-charge transistor comprising a source, a drain and a channel between the source and drain, the channel including a region of semiconductor material which is doped with a dopant, a bias source configured to apply a source-drain bias between the source and drain, a current meter configured to measure drain current and an appliance configured to cool and/or heat the single-charge transistor, and a controller. The controller is configured to cause a source-drain bias to be applied to the single-charge transistor which is at a first temperature so as to drive a given drain current through the channel and to maintain the given drain current through the channel by causing the bias source to adjust the source-drain bias during cooling of the single-charge transistor.

The controller may be further configured to cause the appliance to cool the single-electron transistor to the second temperature.

The apparatus may further comprise a plurality of single-charge transistors, a plurality of bias sources configured to apply a source-drain bias between the source and drain of respective transistors and a plurality of current meters configured to measure drain current of respective transistors. At least one controller is configured to cause a source-drain bias to be applied to each respective single-charge transistor which is at a first temperature so as to drive a given drain current through the channel and to maintain the given drain current through the channel for each transistor by causing the bias source to adjust the source-drain bias during cooling of the single-charge transistor.

The appliance may a refrigerator, such as a closed-cycle cryostat, continuous-flow cryostat, bath cryostat or multi-stage cryostat.

The controller may be a computer system.

Certain embodiments of the present invention will now be described, by way of example, with reference to the accompanying drawings, in which:
Figure 1 is a plan view of a single-electron transistor;
Figure 1a is a cross-sectional view of the single-electron transistor shown in Figure 1 taken along the line A-A';
Figure 2 is a schematic diagram of apparatus for forming a single-dopant trapping centre in a single-electron transistor;
Figure 3 is process flow diagram of a method of forming a single-dopant trapping centre in a single-electron transistor;
Figure 4 is a graph of source-drain voltage against drain current for a single-electron transistor at two different temperatures;
Figure 5a is a band diagram of a single-electron transistor with no source-drain bias applied before being processed;
Figure 5b is a band diagram of a single-electron transistor during possessing;
Figure 5c is a band diagram of a single-electron transistor with no source-drain bias after being processed;
Figure 6 is a schematic plan view of a single-electron transistor after being processed illustrating a position of a dopant forming a single-atom transistor;
Figure 7a is a schematic diagram showing a ground level of a potential well formed by the dopant;
Figure 7b is a schematic diagram showing a first excited state of a potential well formed by the dopant;
Figure 8 illustrates Coulomb blockade of a single-atom transistor; and
Figure 9 illustrates a modified single-electron transistor.

To realise a single- or few-atom transistor, a silicon-based single-electron transistor is electrostatically manipulated during cooling so as to isolate a few or only one donor.

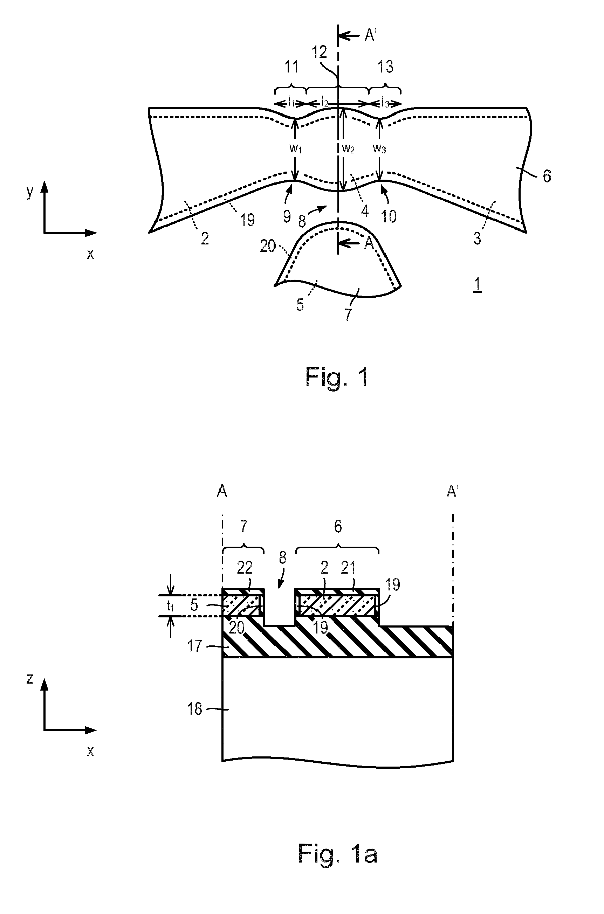

Referring to Figures 1 and 1a, a single-electron transistor 1 is shown. The single-electron transistor 1 comprises first and second contact regions 2, 3 (hereinafter referred to as "source" and "drain" respectively), a channel 4, running between the source 2 and drain 3, and an in-plane side gate 5. The source 2, drain 3 and channel 4 are disposed in a first mesa 6 and the side gate 5 is disposed in a second mesa 7 separated from the first mesa 6 by a trench 8.

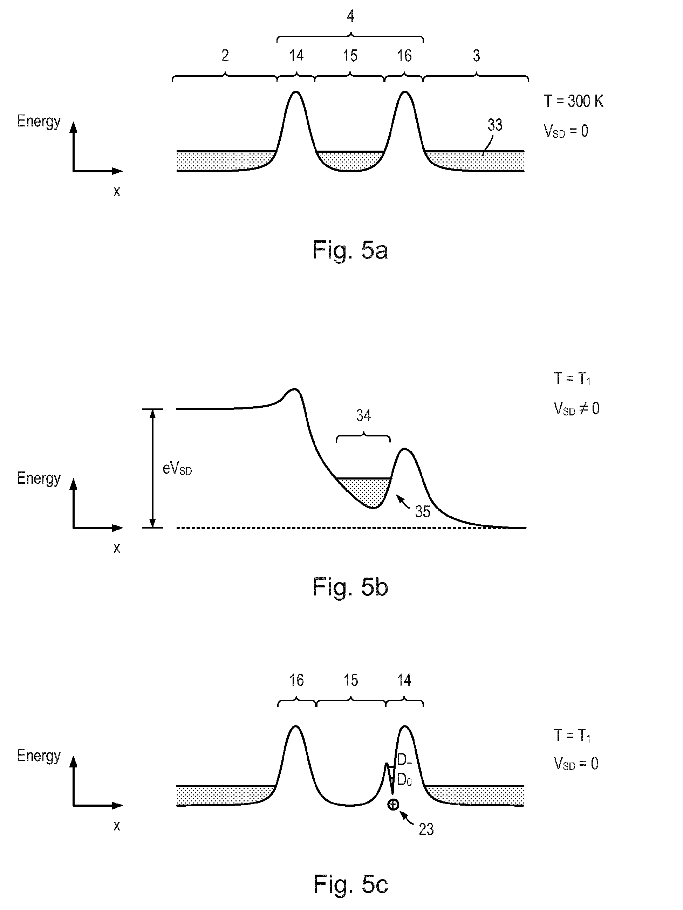

As shown in Figure 1, the first mesa 6 is generally elongated and includes first and second pairs of lateral constructions 9, 10 which divides the mesa 6 into first, second and third sections 11, 12, 13. As will be explained in more detail later, a first tunnel barrier 14 (Figure 5a), a quantum dot 15 (Figure 5a) and a second tunnel barrier 16 (Figure 5a) are formed in the first, second and third sections 11, 12, 13 respectively. The first, second and third sections 11,12,13 have a respective first, second and third lengths, 1₁, 1₂, 1₃, of about 20 nm, 40 nm and 20 nm respectively. The first, second and third sections 11, 12, 13 have a respective first, second and third widths, w₁, w₂, w₃, of about 30 nm, 40 nm and 30 nm respectively

The source 2, drain 3, channel 4 and gate 5 each comprise heavily-doped, n-type monocrystalline silicon having a thickness, t₁, of about 20 to 80 nm, for example 40 nm. The thickness, t₁, may be smaller, for example, between 5 and 10 nm. The source 2, drain 3, channel 4 and gate 5 may comprise different materials and/or may have different thicknesses. The thickness of the channel 4 may vary along the channel 4.

As shown in Figure 1a, the source 2, drain 3, channel 4 and gate 5 lie on a partially-etched layer of silicon dioxide 17 which in turn is directly formed on a p-type monocrystalline silicon substrate 18. The source 2, drain 3, channel 4 and gate 5 are bounded by silicon dioxide side walls 19, 20 and silicon dioxide capping layers 21, 22.

The single-electron transistor 1 is formed by patterning a silicon-on-insulator substrate (not shown) using electron-beam lithography, dry etching and oxidation, for example, as described in EP 2 075 745 A₁.

If the single-electron transistor 1 is cooled to a sufficiently low temperature (for example, below 10 K), it can exhibit Coulomb blockade. The charging energy of the single-electron transistor 1 depends on the size of the quantum well 15 (Figure 5a) which in turn depends on the physical size of the second region 12, silicon dioxide thickness and doping concentration. The charging energy, however, can be increased by cooling the single-electron transistor 1 under controlled bias conditions. As will now be explained, this process is used to isolate a donor 23 (Figure 5c) in or at the edge of the quantum well 15 (Figure 5a) which forms a smaller potential well.

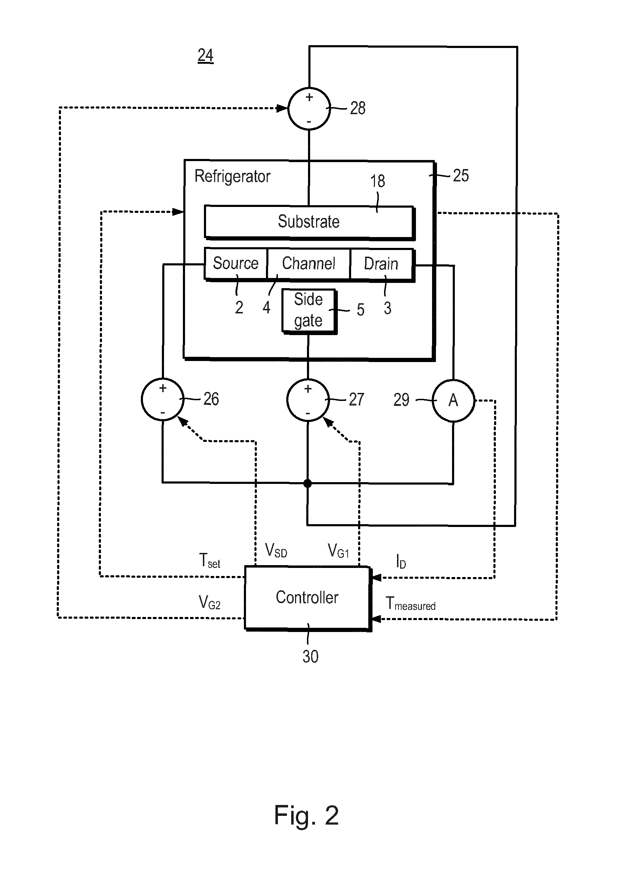

Figure 2 shows apparatus 24 for forming an isolated donor 23 (Figure 5c) in the single-electron transistor 1.

Referring to Figure 2, the apparatus 24 includes a cryostat 25 which is able to set the temperature of the single-electron transistor 1 in a range between, for example, 80 K (i.e. above the glass transition temperature for silicon) and about 4 K. Typically, the glass transition temperature lies between about 60 and 130 K and can be found by routine experiment.

The apparatus 24 includes first, second and third voltage sources 26, 27, 28. The third voltage source 28 is optional. The first voltage source 26 is used to apply a bias, V_{SD}, between the source 2 and drain 3. The second voltage source 26 is used to apply a bias, V_{G1}, to the side gate 5. The third voltage source 27 is used to apply a bias, V_{G2,} to the substrate 18. The apparatus 24 also includes a current meter 29 to measure the drain current, I_{D}.

The apparatus 24 also includes a controller 30 in the form of a computer system to receive measurements, such as drain current, I_{D}, and set voltage biases. The controller 30 may also receive a measurement of temperature, T_{measured}, and set temperature. However, temperature control can be controlled separately and may even be controlled by the user.

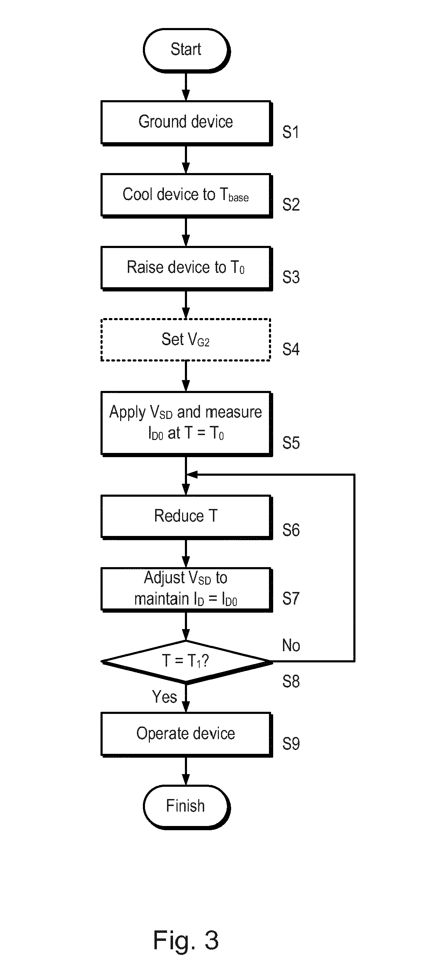

Figure 3 is a process flow diagram of a method of operation by which an isolated donor 23 (Figure 5c) can be formed.

Referring to Figures 1, 2 and 3, the terminals 2, 3, 5, 18 of the single-electron transistor 1 are connected to ground (step S1) and the single-electron transistor 1 is loaded into the cryostat 25 and cooled to a base temperature, for example, 4 K (step S2). The single-electron transistor 1 is warmed up to a temperature T₀ which is above the freeze-out temperature of charge carriers (step S₃). In this example, T₀ is 50 K. The bias of the substrate 18 can be set, for example, to facilitate turn-on (step S4).

Under the control of the controller 30, the first voltage source 26 applies a source-drain bias, V_{SD}, between the source 2 and drain 3 (step S5). The source-drain bias, V_{SD}, can be set to yield a desired drain current, I_{D0}. The single-electron transistor 1 is then slowly cooled to an initial desired operating temperature, T₁ (step S6). For example, the single-electron transistor 1 is cooled from 50 K to 4 K over a period of one or two hours. As the single-electron transistor 1 cools, the controller 30 continuously monitors and maintains the drain current, I_{D0}, by adjusting the source-drain bias, V_{SD}, accordingly. The controller 30 maintains the drain current, I_{D0}, by increasing the source-drain bias, V_{SD}, since the drain current usually decreases with a decrease in device temperature.

The desired drain current, I_{D0}, and required source-drain voltage, V_{SD}, provide significant band bending (for example, by establishing an electric field of 10 mVnm⁻¹ or more) without damaging the single-electron transistor 1 or generating too much heat.

The desired drain current, I_{D0}, may lie in a range between about 0 and 100 nA, for example, in a range between 1 nA and 10 nA. The source-drain voltage, V_{SD}, required to drive the desired drain current, I_{D0}, depends on the channel resistance, R_{ch}. Typically, the channel resistance, R_{Ch} lies in the range between about 100 kΩ, to 1 MΩ. Thus, the required source-drain voltage, V_{SD}, may lie, for example, in a range between about 1 mV and 1 V.

Values of desired drain current, I_{D0}, and required source-drain voltage, V_{SD}, to provide a sufficient degree of band bending can be found by computer modelling and/or by routine experiment, for example, using one or more test devices or structures, such as other single-electron transistor(s), having the same configuration and size as the single-electron transistor 1 to determine an upper limit of current at which the transistor fails.

When the single-electron transistor 1 has reached the desired operating temperature, T₁, the source-drain bias, V_{SD}, is removed and the single-electron transistor 1 is ready to be used, for example, as an electrometer (step S9).

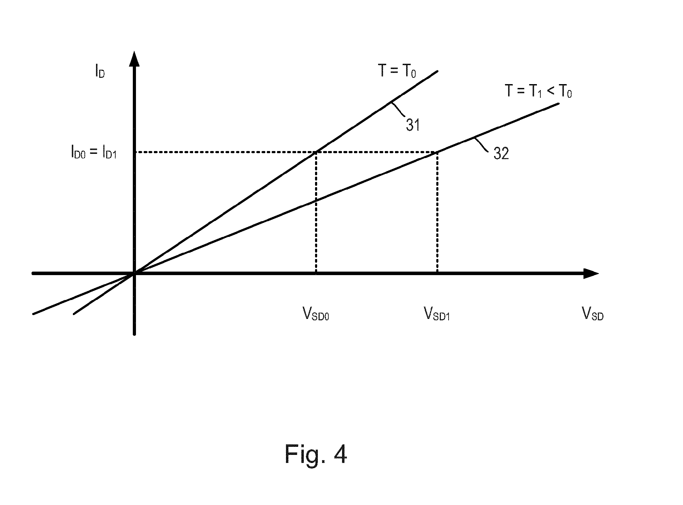

Figure 4 illustrates current-voltage characteristics 31, 32 for the single-electron transistor 1 (Figure 1) at temperatures T₀ and T₁.

As shown in Figure 4, at a higher temperature T₀ at a source-drain bias V_{SD} = V_{SD0} is required to drive a drain current, I_{D} = I_{D0}. At a lower temperature T₁, a higher source-drain bias V_{SD} = V_{SD1} is required to drive the same drain current, I_{D} = I_{D0} = I_{D1}. Conductivity of the single-electron transistor 1(Figure 1) can decrease for one or more reasons such as fewer dopants being activated, due to band tails and/or increased depletion width.

Thus, in order to maintain the same drain current (i.e. I_{D} = I_{D0} = I_{D1}) during cooling from a higher temperature T₀ to a low temperature T₁, the source-drain bias V_{SD} = V_{SD0} is gradually increased.

Figures 5a to 5c illustrate how the process isolates a single donor 23.

The effect of cooling down the single-electron transistor 1 (Figure 1) while maintaining a constant current, I_{DO}, is to maintain a constant tunnelling rate of electrons 33 through the tunnel barriers 14, 16 and to accumulate electrons in a small section 34 of the channel 4 adjacent to the drain-side barrier 16 by forming a deep potential well 35. at high biases, when only one or a few electrons can accumulate, the section 34 has a length of a few nanometres.

At low temperature, if the source-drain bias is removed, then the profile of the conduction band in the region 15 between the tunnel barriers 14, 16 becomes distorted. The region 15 "remembers" the position of the accumulated electron(s). Because no more than a one or a few electrons can be maintained in this position due to electrostatic screening, only one or a few donors remain active. A change in the magnitude of the current has the ability to change the shape of potential and, thus, occupancy of the well. Thus, by setting a sufficiently high level of current and then reducing the temperature while maintaining the current level, a single donor 23 can be selected and isolated.

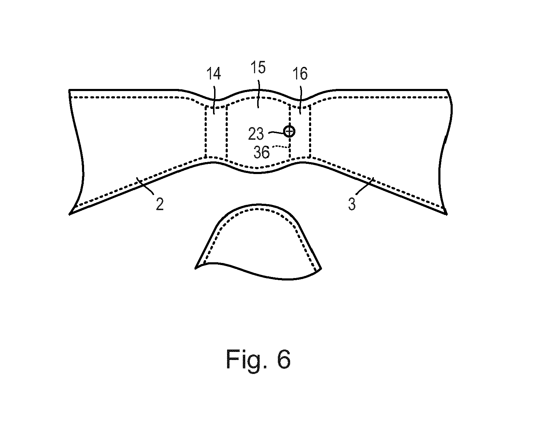

As shown in Figures 5c and 6, the donor 23 is located at an interface 36 between the quantum well 15 and the drain-side tunnel barrier 16.

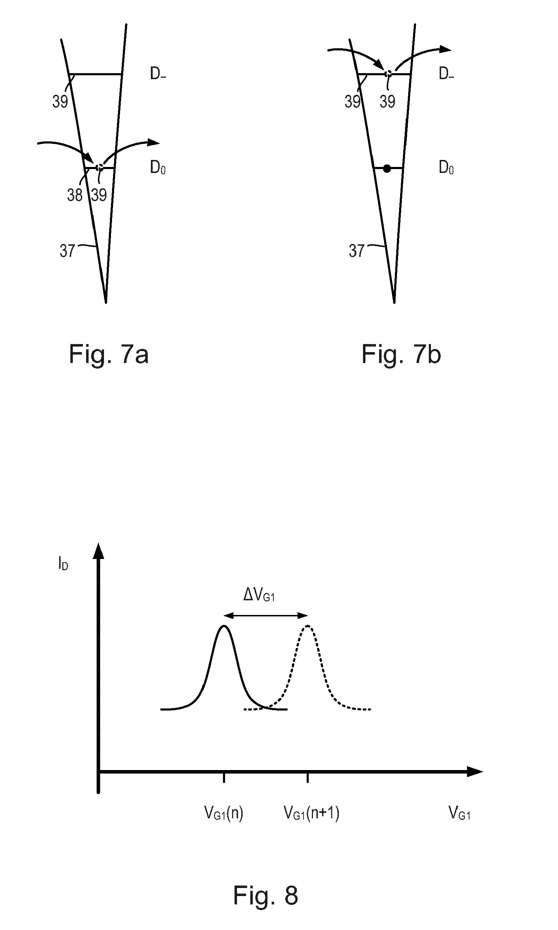

Referring to Figures 7a and 7b, the donor 23 creates a deep potential well 37 with steep walls. Ground and first excited states 38, 39, i.e. D₀ and D_ respectively, are formed in the deep potential well 37.

The single-electron transistor 1 (Figure 1) having a single isolated donor 23 can be used as a sensitive spin or charge detector.

A gate bias is applied to the gate 5 and a source-drain voltage bias is applied across the source 2 and drain 3 to align one of the states 38, 39 with the Fermi level in the source 2.

Figure 7a shows the well 37 when biases are applied such that an electron 39 can tunnel into the well 37 and occupy the ground state 38 before tunnelling out again.

Figure 7b shows the well 37 when biases are applied such that the ground state 38 is occupied and an electron 39 can tunnel into the well 37 and occupy the excited state 39 before tunnelling out again. The excited state 39 is generally more sensitive than the ground state 38 since there only one tunnel transition is possible.

Figure 8 shows a conductance plot of gate bias against current.

As shown in Figure 8, the shift in a conductance peak 40 for n electrons and n +1 electrons is ΔV_{G1}. In the case of a single-electron transistor 1 (Figure 1) having a single isolated donor 23 (i.e. a single-atom transistor) and n = 1, ΔV_{G1} can be of the order of magnitude of 0.1 V or even 1 V thereby making the single-electron transistor 1 (Figure 1) very sensitive. In the case when the single-electron transistor 1 (Figure 1) does not have a single isolated donor, then ΔV_{G1} is generally a few millivolts.

Manipulation of the single-electron transistor 1 (Figure 1) provides a degree of control over the location of the isolated donor. However, the degree of control can be increased.

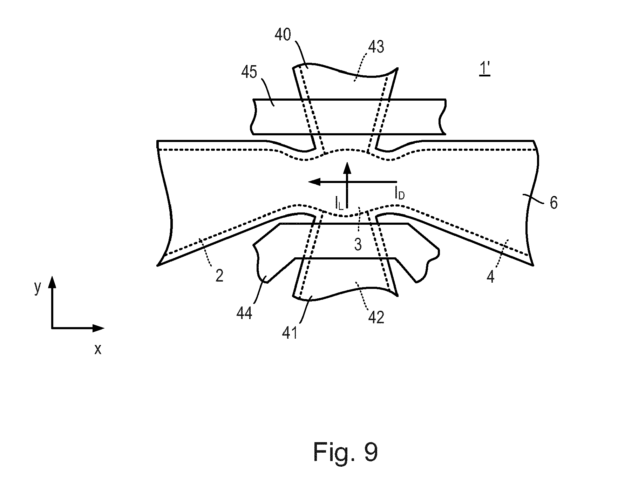

Figure 9 is a plan view of another single-electron transistor 1'is shown.

As shown in Figure 9, the first mesa 6 includes a pair of arms 40, 41 arranged on opposite sides which provide first and second lateral contacts 42, 43 to the channel 4. Thus, current can flow not only between the source 2 and drain 3, but also between the first and second lateral contacts 42, 43.

To accommodate, the lateral arms 40, 41, the second mesa 7 (Figure 1) is omitted. Instead of a side gate 5 (Figure 1), a top gate (not shown) may be used.

First and second surface metal or highly-doped semiconductor gates 44, 45 cross over the arms 40, 41 which can be used to selectively couple and de-couple the first and second lateral contacts 42, 43 from the channel 4 by applying a high negative bias which depletes the underlying regions of the contacts 42, 43.

The first and second lateral contacts 42, 43 can be used to drive a current across the channel 4, i.e. a lateral current I_{L}. The lateral current I_{L} can be used to control the lateral position of the isolated donor. Thus, not only is the drain current I_{D} maintained, but also the lateral current I_{L} is maintained during cool down.

It will be appreciated that many modifications may be made to the embodiments hereinbefore described.

A gate need not be provided, i.e. the device can be a two-terminal device. An external gate may be used, e.g. the gate electrode and channel may be provided by different substrates.

The transistor may be a single-hole transistor. A p-type semiconductor may be used. Thus, an acceptor can be isolated instead of a donor.

The semiconductor material can be germanium (Ge) or silicon germanium (SiₓGe₁₋ₓ).

The single-electron transistor may be used in quantum information processing.

A top gate or bottom gate may be used instead of a side gate. Two gates, for example two side gates, may be used.

The channel may include more than two potential barriers. For example, the device can take the form of a single-charge turnstile or single-charge pump. Thus, a series (or "chain") of two or more isolated dopants can be formed. Each dopant may be provided with a respective gate.

The doping concentration may be different in different regions of the channel. For example, the doping concentration may be relatively high in sections of the channel on one or both sides of a tunnel barrier formed, for example, by a constriction or a dielectric-filled gap, and be relatively low (or even un-doped) in a section further away from tunnel barrier thereby forming, for example, a potential barrier. The doping concentration in the channel may be lower than in the source and drain.

Variations in doping concentration and/or type may be achieved in different ways.

The source, drain and channel may be formed by patterning a layer of semiconductor material (e.g. a silicon layer) having a given doping concentration and dopant concentration may be increased in selective regions(s) by ion implantation or delective diffusion (i.e. by masking and applying a spin-on dopant). Additionally or alternatively, a dopant of opposite type may be introduced in selective region(s). For example, p-type dopant may be introduced into an n-type channel to form potential barriers.

The channel may include regions of selective damage and/or compensation doping.

## Claims

1. A method, comprising:
at a first temperature, applying a source-drain voltage to a single-charge transistor comprising a channel which includes first and second potential barriers and a region of semiconductor material which is disposed between the first and second potential barriers and which is doped, wherein applying the source-drain bias drives a given drain current through the channel;
cooling the single-charge transistor to a second temperature; and
maintaining the given drain current through the channel by adjusting the source-drain bias during cooling of the single-charge transistor.

2. A method according to claim 1, further comprising:
at the second temperature, removing the source-drain bias.

3. A method according to claim 1 or 2, wherein the single-charge transistor includes a gate, the method comprising:
grounding the gate during cooling of the single-charge transistor.

4. A method according to any preceding claim, wherein the source-drain bias has a given value when it is removed at the second temperature, the method comprising:
applying a source-drain bias having a smaller magnitude than the given source-drain bias.

5. A method according to any preceding claim, wherein the semiconductor material is silicon.

6. A method according to any preceding claim, wherein the semiconductor material is doped with an n-type dopant.

7. A method according to any preceding claim, wherein the channel comprises an elongate region of the semiconductor material.

8. A method according to any preceding claim, wherein the channel includes:
at least first and second constrictions,
wherein the semiconductor material region is interposed between the first and second constrictions.

9. A method according to any preceding claim, wherein channel includes:
at least first and second regions of material having a conductivity which is lower than the doped semiconductor material.

10. A method according to any preceding claim, wherein the single-charge transistor further includes:
first and second arms oppositely attached to the channel so as to form a cross;
wherein the semiconductor material region is disposed at an intersection of the cross.

11. Apparatus comprising:
a single-charge transistor comprising:
a source;
a drain;
a channel between the source and drain, the channel including:
first and second potential barriers; and
a region of semiconductor material which is disposed between the first and second potential barriers and which is doped;
a bias source configured to apply a source-drain bias between the source and drain regions;
a current meter configured to measure drain current; and
an appliance configured to cool and/or heat the single-charge transistor;
a controller;
wherein the controller is configured:
to cause a source-drain bias to be applied to the single-charge transistor which is at a first temperature so as to drive a given drain current through the channel;
to maintain the given drain current through the channel by causing the voltage bias to adjust the source-drain bias during cooling of the single-charge transistor.

12. Apparatus according to claim 11, wherein the controller is further configured:
to cause the appliance to cool the single-electron transistor to the second temperature.

13. Apparatus according to claim 11 or 12, comprising:
a plurality of single-charge transistors;
a plurality of bias sources, each bias source configured to apply a source-drain bias between the source and drain regions of a respective transistor;
a plurality of current meters, each current meter configured to measure drain current of a respective transistor; and
at least one controller configured:
to cause a source-drain bias to be applied to each respective single-charge transistor which is at a first temperature so as to drive a given drain current through the channel;
to maintain the given drain current through the channel for each transistor by causing the voltage source to adjust the source-drain bias during cooling of the single-charge transistor.

14. Apparatus according to any one of claims 11 to 13, wherein the appliance is a refrigerator.

15. Apparatus according to any one of claims 11 to 14, wherein the controller is a computer system.
